Europäisches Patentamt

European Patent Office

Office européen des brevets

(11) Publication number: **0 086 210**
**B1**

# (12) EUROPEAN PATENT SPECIFICATION

(45) Date of publication of patent specification: **10.07.85**

(51) Int. Cl.⁴: **H 01 L 29/91, H 01 L 29/06**

(21) Application number: **82902481.9**

(22) Date of filing: **19.08.82**

(86) International application number:
**PCT/SE82/00266**

(87) International publication number:
**WO 83/00776 03.03.83 Gazette 83/06**

(54) **DIODE FOR MONOLITHIC INTEGRATED CIRCUIT.**

(30) Priority: **25.08.81 SE 8105040**

(43) Date of publication of application:
**24.08.83 Bulletin 83/34**

(45) Publication of the grant of the patent:
**10.07.85 Bulletin 85/28**

(84) Designated Contracting States:
**DE FR GB NL**

(56) References cited:
**EP-A-0 017 021**
**EP-A-0 017 022**
**US-A-3 930 909**
**US-A-4 027 325**
**US-A-4 117 507**
**US-A-4 272 307**

(73) Proprietor: **TELEFONAKTIEBOLAGET L M ERICSSON**
**S-126 25 Stockholm (SE)**

(72) Inventor: **EKLUND, Klas-Hakan**
**Jungfrudansen 20**
**S-171 56 Solna (SE)**

(74) Representative: **Johnsson, Helge et al**
**Telefonaktiebolaget L M Ericsson**
**S-126 25 Stockholm (SE)**

Courier Press, Leamington Spa, England.

## Description

Technical field

The present invention relates to a semiconductor diode particularly suited for use in electronic circuits of the monolithic type, driven by voltages above the emitter-base breakdown voltages of normal transistors, i.e. about 7 V.

Background art

In the prior art, one of the transistor's p-n junctions is used when a diode element is desired in monolithic integrated circuits.

A p-type substrate is the starting point in the manufacture of circuits containing an n-p-n transistor. A heavily n-doped region is diffused into the substrate, the so-called "buried layer", which is provided to reduce the resistance of the collector. An n-doped collector layer is then grown epitaxially. An annular heavily p-doped region has been allowed to diffuse right down to the substrate. By putting the substrate, and thereby the annular p-region as well, on the lowest potential of the circuit, the transistor will be in a region which is isolated from the remaining part of the circuit. After the isolation diffusion there is a diffusion of p-dopants, so that the base is formed, after which the emitter region and the collector contact region are simultaneously diffused in. Metallized contacts are finally applied to base, emitter and collector.

Both the base-emitter junction and the base-collector junction can be used to obtian a diode. The former has a breakdown voltage of about 7 V however, and for higher voltages one is therefore required to use the base-collector junction, the base region becoming anode and the collector region becoming cathode. There is simultaneously obtained a parasite transistor, the emitter and base of which are common with the diode's anode and cathode, and the collector of which is formed by the substrate. When the diode is biassed in the conductive direction, the transistor will also be open and lead current to the substrate. Without the n region, $h_{FE}$ can be 1 or greater, so that more than half of the diode current can be led off to the substrate. With its heavy doping, the buried layer will increase the recombination of the charge carriers which diffuse down towards the substrate and thereby reduce the substrate current. A further reduction is obtained by allowing the collector contact region to form a ring round the anode region. In the same way, this ring then counteracts the current reaching the isolation region.

Attempts to further reduce the substrate current are accounted for in the published Swedish patent applications 77070688 and 7707251-0. The former discloses utilization of the condition that the efficiency of the emitter of the parasite transistor can be deteriorated by connecting together the n-p-n transistor's emitter with the diode's anode. The latter application also deals with growing a p-doped zone round the anode. The isolation region takes up considerable space in transistors intended for high voltages. The thickness of the epitaxial layer must namely be increased for increased voltage, to provide room for the deeper depletion region for the collector-base junction of the transistors. When the isolation region must thus be diffused further down, the region will require greater space due to the simultaneous lateral diffusion. It is known to reduce this space by a technique where, before putting down the epitaxial layer, there are deposited dopants of the same kind as those used in the isolation diffusion under the regions where the isolation diffusion will take place later on. By allowing these dopants to diffuse up into the epitaxial layer, an isolation region of less extent is obtained together with the isolation region diffused from above.

In transistors for higher voltages, it is also known to lower the collector's resistance by allowing the collector's heavily-doped contact region to extend down to the buried layer.

Disclosure of invention

The utilization of all the above-mentioned measures can reduce the substrate current to about 5% of the diode current. Even this reduced substrate current gives rise to problems in circuits for higher voltages, due to the power loss it causes when the diode is close to the positive potential of the circuit.

For example, with a diode current of 500 mA in the conductive direction, 5% substrate leakage current means an extra power loss of 1 Watt when the diode is at about 40 V above the substrate potential. This power loss is of the same order of magnitude as the power loss obtained for a given circuit and therefore is a clear limitation of the loading capacity thereof.

In accordance with the invention it is possible to reduce the substrate leakage current to entirely negligible values. This is achieved with a diode which is formed in bhe mode apparent from the appended claim.

Brief description of drawings

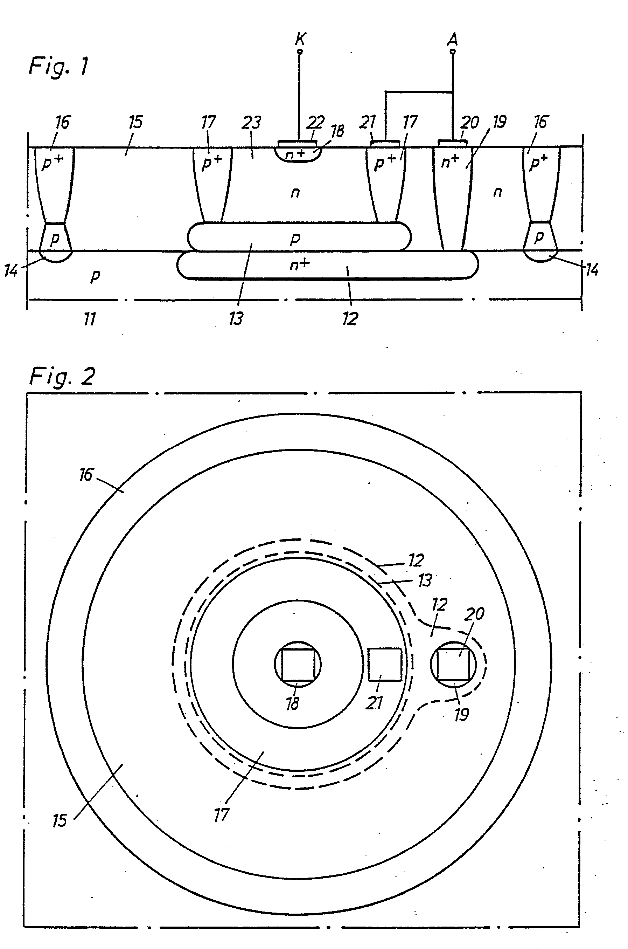

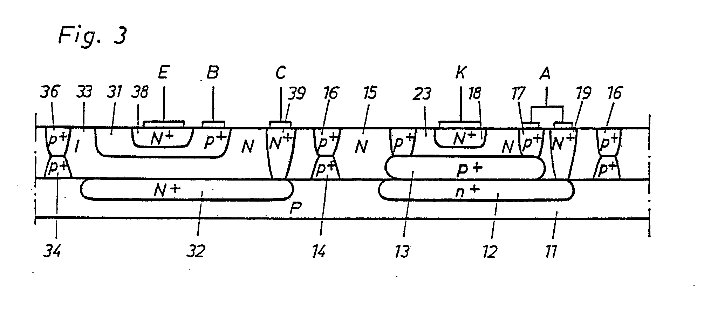

Figure 1 illustrates in section, and Figure 2 in a plan view, the principle for a monolithic integrated diode implemented in accordance with the invention. Figure 3 illustrates a detail of an integrated circuit with a diode in accordance with the invention.

Mode for carrying out the invention

In the figures, the numeral 11 denotes a p-type silicon semiconductor substrate provided with a first n-type buried layer forming a heavily $n^+$-doped region 12. Over the buried layer 12 there is a second p-type bottom diffusion 13 as well as a lower outer p-type isolation ring 14. There is an epitaxial n layer 15 grown on the substrate. An upper, outer isolation ring 16 which reaches down to the lower isolation ring 14 and an inner ring 17, which reaches down to the bottom diffusion 13 are diffused into this layer. The ring 17 and bottom diffusion 13 constitute the diode anode.

All of these regions are of the $p^+$ type. In the n region 23, forming the diode cathode, there is an $n^+$-contact diffusion 18. An $n^+$ diffusion 19 connects the buried layer 12 with the surface of the semiconductor wafer where it is provided with a contact 20, which is connected to the contact 21 on the anode terminal. This terminal has the task of giving the region 12 a defined potential, since the p-n junction 13—12 can be biassed so that current can flow to the substrate at rapid current variations when the diode changes from a conductive to a non-conductive state.

The reason for the region 19 being diffused right down to the region 12 is that a low-resistance current path is required down to this region. A major portion of the diode current in the forward direction will take this path as the layer 12 acts as collector in the transistor formed by the layers 12, 13 (base) and 23 (emitter). If the series resistance in the circuit down to the lower diffusion is large, there is the risk that the junction between the $n^+$ layer 12 and the $p^+$ layer 13 will be given a bias in the reverse direction, whereby current leakage can take place to the substrate. On the other hand, if the layers 12 and 13 are kept at practically the same potential, the leakage is negligible, apart from a very small current in the reverse direction.

As an example of a diode in accordance with the invention, a circuit intended for operation at 40 V has been manufactured. The epitaxial layer 15 had a resistivity of 3 ohms cms and was 16 µm thick. The $p^+$ diffusion 13 was about 8 µm thick and the distance between this region and the cathode contact region 18 was 5 µm. When a current of 500 mA passed the diode in the conductive direction a substrate current of less than 1 µmA was measured. The power loss of the circuit was otherwise under 0,5 W, the increment from the substrate leakage current thus being completely negligible. This may be compared with the best diodes of the known art, where the substrate leakage current attains about 5% of the diode current. If the diode is at 40 V above the substrate potential, this means a power loss of about 1 W, i.e. double the power loss for the diode circuit itself.

The diode in accordance with the invention can be completely manufactured according to the techniques used for manufacturing transistors intended for high voltage in integrated circuits. This will be seen from Figure 3, illustrating a diode in accordance with the invention and a transistor T, both in the same substrate 11. The transistor T has its collector layer 33 in the epitaxial layer 33. Under the layer 33 there is an $n^+$-type sub-collector layer which is connected to the collector contact C via the $n^+$ diffusion. The base layer 31 and emitter layer 38 are diffused conventionally into the collector layer. The transistor isolation diffusion 36 is produced in two steps in the same manner as is illustrated for the diode in Figure 2.

The following diffusion steps are used in manufacture:

1. Growing dopants for the $n^+$ regions 12 and 32.
2. Diffusion of the dopants according to item 1.
3. Growing dopants for the $p^+$ regions 13, 14 and 34.
4. Application of the epitaxial n-doped layer 15.
5. Growing the dopants for the $p^+$ regions 16, 17 and 36.
6. Growing the dopants to the $n^+$ regions 19 and 39.
7. Diffusion of the dopants grown according to items 5 and 6.
8. Growing dopant on to the p-doped base region 31 in the transistor.
9. Diffusion of the dopant according to item 8.
10. Growing dopants for the cathode contactor region 18 and the emitter 38.
11. Diffusion of the regions according to item 10.

These steps are entirely conventional and are described in the prior art.

## Claim

A semiconductor diode intended for incorporation in integrated circuits also including transistors and formed in a substrate (11) of a first conduction type (p) provided with a heavily-doped buried layer (12) of the second conduction type (n) and an epitaxial layer (15) lying thereabove of the second conduction type (n) in which one layer (23) of the diode is formed and to which a contact (22) is connected to constitute one pole (K) of the diode, characterized by a second heavily-doped bottom diffusion (13) of the first conduction type (p) situated immediately above the buried layer (12), an annular heavily-doped region (17) of the first conduction type (p) surrounding said one layer (23) of the diode and making contact with the second bottom diffusion (13) and by a heavily-doped contact diffusion (19) of the second conduction type (n) making contact with said buried layer (12), connections (20, 21) to the annular region (17) and the contact diffusion (19) being connected together to constitute the second pole (A) of the diode.

## Patentanspruch

Halbleiterdiode für den Einbau in auch Transistoren enthaltende integrierte Schaltungen, welche in einem Substrat (11) eines ersten Leitungstyps (p) ausgebildet sind, versehen mit einer stark gedopten überdeckten Schicht (12) des zweiten Leitungstyps (n) und einer über der Schicht des zweiten Leitungstyps (n) liegenden Epitaxialschicht (15), in welcher eine Schicht (23) der Diode ausgebildet ist und mit welcher ein Kontakt (22) zum Bilden eines Pols (K) der Diode verbunden ist, gekennzeichnet durch eine unmittelbar über der überdeckten Schicht (12) angeordnete zweite stark gedopte Bodendiffusion (13) des ersten Leitungstyps (p), einen eine Schicht (23) der Diode umgebenden und Kontakt mit der zweiten Bodendiffusion (13) gebenden, ringförmigen star gedopten Bereich (17) des ersten Leitungstyps (p), und durch eine mit der überdeckten Schicht (12) Kontakt gebende, stark gedopte Kontaktdiffusion (19) des zweiten Leitungstyps (n), wobei Verbindungen (20, 21) zu dem ringförmigen Bereich (17) und der Kontaktdiffusion (19) zur Bildung des zweiten Pols (A) der Diode miteinander verbunden sind.

**Revendication**

Diode semiconductrice conçue pour être incorporée dans des circuits intégrés comprenant également des transistors et formés dans un substrat (11) d'un premier type (p) de conduction, recevant une couche enterrée fortement dopée (12) du second type (n) de conduction et une couche épitaxiale (15) s'étendant au-dessus de la précédente et du second type (n) de conduction, dans laquelle une première couche (23) de la diode est formée et à laquelle un contact (22) est connecté pour constituer un premier pôle (K) de la diode, caractérisée par une seconde diffusion de fond fortement dopée (13) du premier type (p) de conduction, située immédiatement au-dessus de la couche enterrée (12), une région annulaire fortement dopée (17) du second type (p) de conduction entourant une première couche (23) de la diode et établissant un contact avec la seconde diffusion de fond (13) et par diffusion du contact fortement dopée (19) du second type (n) ne conduction établissant un contact avec ladite couche enterrée (12), des connexions (20, 21) sur la région annulaire (17) et la diffusion de contact (19) étant connectées ensemble pour constituer le second pôle (A) de la diode.

**Fig. 1**

**Fig. 2**

# Fig. 3